(19) Europäisches Patentamt
European Patent Office
Office européen des brevets

(11) **EP 3 798 361 B1**

(12) **EUROPÄISCHE PATENTSCHRIFT**

(45) Veröffentlichungstag und Bekanntmachung des Hinweises auf die Patenterteilung:
**08.05.2024 Patentblatt 2024/19**

(21) Anmeldenummer: **20198005.9**

(22) Anmeldetag: **24.09.2020**

(51) Internationale Patentklassifikation (IPC):
**E01C 19/42** *(2006.01)*     **E01C 19/40** *(2006.01)*

(52) Gemeinsame Patentklassifikation (CPC):
**E01C 19/42; E01C 19/40; E01C 19/4833**

(54) **GLEITSCHALUNGSFERTIGER MIT EINER ÜBERWACHUNGSVORRICHTUNG ZUR ÜBERWACHUNG DER VERDICHTUNG VON BETON UND VERFAHREN ZUR ÜBERWACHUNG DER VERDICHTUNG VON BETON WÄHREND DES BETRIEBS EINES GLEITSCHALUNGSFERTIGERS**

SLIP-FORM PAVER HAVING A MONITORING DEVICE FOR MONITORING THE COMPRESSION OF CONCRETE AND METHOD FOR MONITORING THE COMPRESSION OF CONCRETE DURING OPERATION OF A SLIP-FORM PAVER

MACHINE À COFFRAGES GLISSANTS AVEC UN DISPOSITIF DE SURVEILLANCE PERMETTANT DE SURVEILLER LE COMPACTAGE DU BÉTON ET PROCÉDÉ DE SURVEILLANCE DU COMPACTAGE DU BÉTON LORS DU FONCTIONNEMENT D'UNE MACHINE À COFFRAGES GLISSANTS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.09.2019 DE 102019125590**

(43) Veröffentlichungstag der Anmeldung:
**31.03.2021 Patentblatt 2021/13**

(73) Patentinhaber: **Wirtgen GmbH**
**53578 Windhagen (DE)**

(72) Erfinder:
• **Dahm, Martin**
**57610 Altenkirchen (DE)**
• **Müller, Adrian**
**56593 Niedersteinebach (DE)**

(74) Vertreter: **Oppermann, Frank**
**OANDO Oppermann & Oppermann**
**Wilhelminenstrasse 1a**
**65193 Wiesbaden (DE)**

(56) Entgegenhaltungen:
EP-A2- 2 942 867      EP-B1- 1 103 659
DE-A1- 10 354 002

EP 3 798 361 B1

## Beschreibung

Die Erfindung betrifft einen Gleitschalungsfertiger mit einer Überwachungsvorrichtung zur Überwachung der Verdichtung von in eine Gleitschalung eines Gleitschalungsfertigers eingebrachten Betons mit mindestens einer Betonverdichtungsvorrichtung, die einen Asynchronmotor zum Antrieb einer Vibrationen erzeugenden Unwucht aufweist. Darüber hinaus betrifft die Erfindung ein Verfahren zur Überwachung der Verdichtung von in eine Gleitschalung eines Gleitschalungsfertigers eingebrachten Betons mit mindestens einer Betonverdichtungsvorrichtung, die einen Asynchronmotor zum Antrieb einer Vibrationen erzeugenden Unwucht aufweist, während des Betriebs des Gleitschalungsfertigers.

Die bekannten Gleitschalungsfertiger verfügen über eine Gleitschalung, die auch als Betonmulde bezeichnet wird. Ein Gleitschalungsfertiger ist beispielsweise in der EP 1 103 659 B1 beschrieben. Mit der Gleitschalung können Baukörper unterschiedlicher Ausbildung, beispielsweise Schutzwände, Bordsteine oder ganze Fahrbahnen aus Beton hergestellt werden. Der Beton wird kontinuierlich in die Gleitschalung eingebracht, die sich mit gleichbleibender Geschwindigkeit über den Untergrund bewegt. In der Gleitschalung muss sich stets eine gewisse Menge an Beton befinden, so dass durch das Eigengewicht auf den Beton ein ausreichender Druck ausgeübt wird. In und/oder vor der Gleitschalung muss der Beton verdichtet werden. Zur Verdichtung des Betons finden Betonverdichtungsvorrichtungen Verwendung, die an oder in der Gleitschalung vorgesehen sind. Diese Betonverdichtungsvorrichtungen werden auch als Außen- oder Innenrüttler bezeichnet. Die Gleitschalungsfertiger verfügen vielfach über mehrere flaschen- oder stabförmige Innenrüttler, die in und/oder vor die Gleitschalung gehangen werden und im Betrieb in den Beton eintauchen.

Es sind elektrische Betonrüttler bekannt, die einen Asynchronmotor aufweisen, der eine exzentrische Schwungmasse (Unwucht) antreibt, die in Vibrationen versetzt wird. Die Verdichtungsleistung des Rüttlers ist von der Frequenz der Vibrationen abhängig, die wiederum von der Drehzahl des Asynchronmotors bestimmt wird.

Beim Betrieb eines Gleitschalungsfertigers stellt sich das Problem, dass technische Defekte der Betonrüttler dazu führen können, dass der Beton in der Gleitschalung nicht ausreichend verdichtet wird. Insbesondere beim Betrieb von Innenrüttlern, die vollständig in den Beton eintauchen, können technische Defekte der einzelnen Rüttler von dem Bedienpersonal des Gleitschalungsfertigers nur schwer erkannt werden. Da ein nachträgliches Verdichten nicht möglich ist, können Bauteile gefertigt werden, bei denen der Beton stellenweise nicht den Anforderungen entspricht. Diese Betonbauteile müssen aufgrund ihrer mangelnden Festigkeit abgerissen und neu gefertigt werden, was mit einem enormen Kostenaufwand verbunden ist.

Die DE 103 54 002 A1 beschreibt einen elektrisch angetriebenen Innenrüttler mit einer Drehzahlregelung. Zur Erkennung des Betriebszustandes des Rüttlers wird eine Vorrichtung vorgeschlagen, die den Schalldruck oder die Vibrationen erfasst. Zur Erfassung des Schalldrucks bzw. der Vibrationen werden Mikrofone bzw. Beschleunigungssensoren vorgeschlagen, die an dem Betonrüttler vorzusehen sind. Nachteilig ist, dass die Mikrofone und Beschleunigungssensoren den rauen Umgebungsbedingungen ausgesetzt sind. Derartige Sensoren, die außen an den Betonrüttlern angebracht werden, sind nicht nur den Vibrationen, sondern auch dem Beton ausgesetzt, der aufgrund seiner Gesteinskörner eine stark schleifende Wirkung hat. Aus diesem Grund müssen die Sensoren wie die Außenhülle des Rüttlers aus einem entsprechend harten Werkstoff gefertigt sein. Die Anordnung eines Sensors innerhalb des Rüttlers ist aufgrund des begrenzten Bauraums sehr schwierig.

Die EP 2 942 867 A2 befasst sich mit dem Problem der Überwachung des ordnungsgemäßen Betriebszustandes eines Asynchronmotors, der in industriellen Anwendungen eine kritische Komponente darstellt. Die EP 2 942 867 A2 beschreibt ein Verfahren zur Bestimmung der Drehzahl eines Asynchronmotors, das auf einer Analyse des Statorstroms beruht, und schlägt vor, mit einer schnellen Fouriertransformation (FFT) das Amplitudenspektrum des Statorstroms zu bestimmen, um den Schlupf des Asynchronmotors ermitteln zu können, und aus dem Schlupf auf die Drehzahl des Asynchronmotors zu schließen.

Der Erfindung liegt die Aufgabe zugrunde, einen Gleitschalungsfertiger mit einer Überwachungsvorrichtung zu schaffen, die während des Betriebs des Gleitschalungsfertigers unter den rauen Umgebungsbedingungen eine zuverlässige Überwachung der Verdichtung des in die Gleitschalung eingebrachten Betons ermöglicht. Eine weitere Aufgabe der Erfindung ist, ein Verfahren anzugeben, das eine zuverlässige Überwachung der Verdichtung des in die Gleitschalung eingebrachten Betons erlaubt. Der Erfindung liegt auch die Aufgabe zugrunde, die Verwendung konventioneller Betonrüttler zu ermöglichen, die nicht mit Sensoren zur Überwachung des Betriebszustandes ausgerüstet sind oder ausgerüstet werden müssten.

Die Lösung dieser Aufgaben erfolgt erfindungsgemäß mit den Merkmalen der unabhängigen Patentansprüche. Die abhängigen Ansprüche betreffen vorteilhafte Ausführungsformen der Erfindung.

In Versuchen hat sich gezeigt, dass beim Betrieb einer Betonverdichtungseinrichtung, bei der die exzentrische Schwungmasse (Unwucht) mit einem Asynchronmotor angetrieben wird, sich die Rotorwelle aufgrund der Unwucht während des Betriebs des Asynchronmotors plastisch verformen kann. Wenn sich die Rotorwelle durchbiegt, verändert sich die Breite des Luftspaltes zwischen Stator und Rotor, was im Amplitudenspektrum des Statorstroms nachgewiesen werden kann. Es hat sich gezeigt, dass unter allen Umgebungsbedingungen das Amplitudenspektrum immer bestimmte charakteristische Merkmale aufweist, wenn die Betonverdichtungsvorrichtung mit der vorgegebenen Rotorfrequenz (Drehzahl) ordnungsgemäß arbeitet, d. h. die tatsächliche Drehzahl des Betonrüttlers nicht von der gewünschten Drehzahl abweicht.

Die erfindungsgemäße Überwachungsvorrichtung und das erfindungsgemäße Verfahren zeichnen sich dadurch aus, dass auf der Grundlage einer Analyse des Statorstroms des Asynchronmotors auf eine Veränderung der Verdichtung des in die Gleitschalung des Gleitschalungsfertigers eingebrachten Betons geschlossen wird. Die erfindungsgemäße Überwachungsvorrichtung verfügt über eine Einrichtung zur Überwachung des Statorstroms des Asynchronmotors, die derart konfiguriert ist, dass auf der Grundlage einer Analyse des Statorstroms auf eine Veränderung der Verdichtung des Betons geschlossen wird. Der Statorstrom kann über einen Stromwandler abgegriffen werden, der eine potentialfreie Messung des Statorstroms erlaubt. Der Statorstrom kann aber auch direkt gemessen werden. Die Einrichtung zur Überwachung des Statorstroms des Asynchronmotors ist vorzugsweise derart konfiguriert, dass zur Analyse des Statorstroms das Amplitudenspektrum des Statorstroms ermittelt wird.

Die erfindungsgemäße Überwachungsvorrichtung und das erfindungsgemäße Verfahren haben den entscheidenden Vorteil, dass die Überwachung der Verdichtung des Betons nicht mittels Bauteilen, insbesondere empfindliche Sensoren, im Umfeld des Betonrüttlers erfolgt, welche den rauen Umgebungsbedingungen während des Betriebs des Gleitschalungsfertigers ausgesetzt sind. Daher besteht nicht die Gefahr, dass derartige Bauteile ausfallen könnten, wodurch die Überwachung nicht zuverlässig wäre.

Die Einrichtung zur Überwachung des Statorstroms des Asynchronmotors ist eine digitale Signalverarbeitungseinrichtung, die derart konfiguriert ist, dass der Statorstrom abgetastet wird, wobei das Amplitudenspektrum des Statorstroms durch eine zeitdiskrete Fouriertransformation (DFT), insbesondere eine zeitdiskrete schnelle Fouriertransformation (FFT), des Statorstroms ermittelt wird. Die hierzu erforderlichen Signalverarbeitungsverfahren gehören zum Stand der Technik.

Die Einrichtung zur Überwachung des Statorstroms ist derart konfiguriert, dass die Verteilung von einzelnen Harmonischen über der Frequenz der spektralen Anteile, welche auf die Unwucht zurückzuführen sind, fortlaufend ermittelt wird und mit einer für eine vorgegebene Drehzahl des Asynchronmotors charakteristischen Verteilung von einzelnen Harmonischen über der Frequenz der spektralen Anteile verglichen wird. Es hat sich in Versuchen gezeigt, dass sich die auf die Unwucht zurückzuführen Harmonischen von den auf die bekannte Netzfrequenz zurückzuführenden Harmonischen deutlich unterscheiden, so dass eine entsprechende Auswahl unter den im Amplitudenspektrum auftretenden Harmonischen getroffen werden kann. Bei einer Abweichung der Verteilung von den einzelnen Harmonischen wird ein Steuersignal erzeugt, das eine Veränderung der Verdichtung des in die Gleitschalung des Gleitschalungsfertigers eingebrachten Betons signalisiert. In diesem Fall wird darauf geschlossen, dass die Verdichtung des Betons nicht ordnungsgemäß ist.

In diesem Zusammenhang wird unter einer fortlaufenden Ermittlung der Verteilung von einzelnen Harmonischen eine Ermittlung der Harmonischen zu mindestens zwei aufeinanderfolgenden Zeitpunkten verstanden, um die Betonverdichtungsvorrichtung über zumindest einen Teil der Betriebsdauer überwachen zu können oder einen Vergleich zwischen einem vorhergehenden Zeitpunkt und einem nachfolgenden Zeitpunkt vornehmen zu können, so dass eine Veränderung des Zustandes erkannt werden kann. Grundsätzlich ist aber auch nur eine einzige Messung möglich.

Die für eine vorgegebene Rotorfrequenz (Drehzahl) des Asynchronmotors charakteristische Verteilung von einzelnen Harmonischen kann empirisch ermittelt werden und in einem Speicher der Überwachungsvorrichtung gespeichert werden. Die zulässigen Abweichungen können beispielsweise durch geeignete Schwellwerte oder bestimmte Frequenzbereiche, in denen die einzelnen ausgewählten Harmonischen liegen sollen, definiert werden.

Die Einrichtung zur Überwachung des Statorstroms des Asynchronmotors kann derart konfiguriert sein, dass zur Analyse des Statorstroms des Asynchronmotors ein Schwellwert für die Amplituden der Harmonischen vorgegeben wird, wobei die Verteilung von einzelnen Harmonischen über der Frequenz der spektralen Anteile, die über dem Schwellwert liegen, fortlaufend ermittelt wird. Folglich werden kleine Amplituden, die im Bereich des Rauschens liegen und keine zuverlässigen Informationen liefern können, ausgeblendet.

Bei einer Ausführungsform weist die Überwachungsvorrichtung eine das Steuersignal empfangende Signaleinheit auf, die derart ausgebildet ist, dass mit einem akustischen und/oder optischen und/oder einem taktilen Signal eine nicht ordnungsgemäße Verdichtung des Betons beim Betrieb des Gleitschalungsfertigers angezeigt wird, wenn die Signaleinheit das Steuersignal empfängt. Die Überwachungsvorrichtung kann auch derart ausgebildet sein, dass mit einem akustischen und/oder optischen und/oder einem taktilen Signal eine ordnungsgemäße Verdichtung des Betons beim Betrieb des Gleitschalungsfertigers angezeigt wird, wenn die Signaleinheit das Steuersignal nicht empfängt. Sind an dem Gleitschalungsfertiger mehrere Betonverdichtungsvorrichtungen vorhanden, kann die Überwachungsvorrichtung diese vorzugsweise einzeln überwachen. Zeigt die Überwachungsvorrichtung eine nicht ordnungsgemäße Verdichtung mit einem Signal an, so erfolgt vorzugsweise auch eine Anzeige an welcher der Verdichtungsvorrichtungen keine ordnungsgemäße Verdichtung erfolgt.

Das Steuersignal kann auch der zentralen Steuereinheit des Gleitschalungsfertigers zugeführt werden, um einen Eingriff in die Maschinensteuerung vorzunehmen. Der Eingriff in die Maschinensteuerung kann darin liegen, dass der Gleitschalungsfertiger angehalten wird.

Die Einrichtung zur Überwachung des Statorstroms kann Bestandteil der zentralen Steuereinheit des Gleitschalungsfertigers sein kann.

Im Folgenden wird ein Ausführungsbeispiel der Erfindung unter Bezugnahme auf die Zeichnungen näher erläutert.

Es zeigen:

Fig. 1 einen Gleitschalungsfertiger mit einer Überwachungsvorrichtung zur Überwachung der Verdichtung von Beton in der Seitenansicht,

Fig. 2 ein Blockschaltbild der Überwachungsvorrichtung und

Fig. 3 das Amplitudenspektrum des Statorstroms des Asynchronmotors einer Betonverdichtungsvorrichtung.

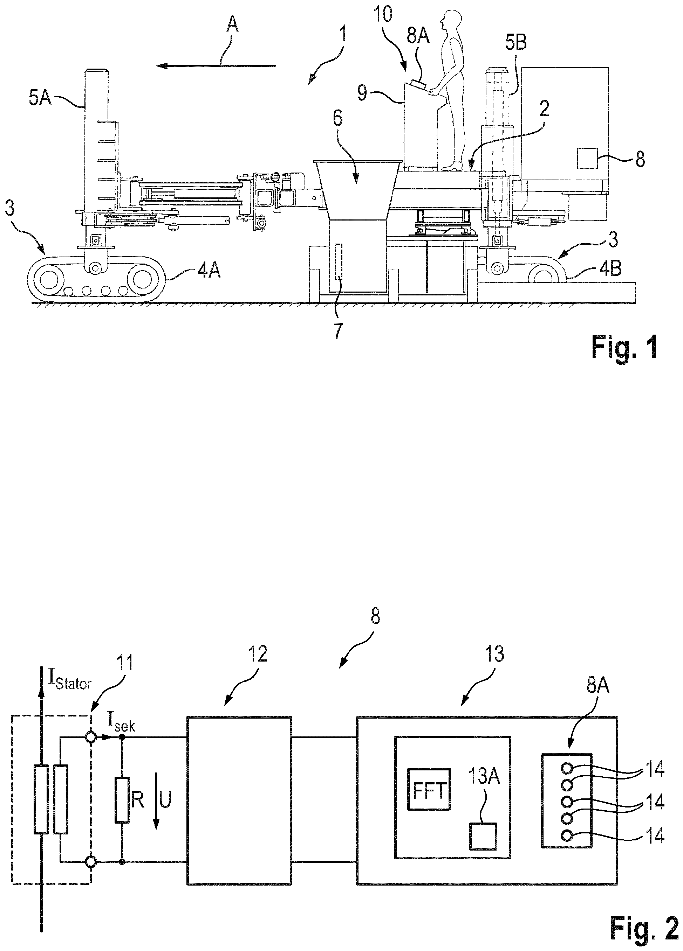

Fig. 1 zeigt ein Ausführungsbeispiel eines Gleitschalungsfertiger in der Seitenansicht ohne Fördereinrichtung, der in der EP 1 103 659 B1 im Einzelnen beschrieben ist. Da Gleitschalungsfertiger als solche zum Stand der Technik gehören, werden hier nur die für die Erfindung wesentlichen Komponenten der Baumaschine beschrieben.

Der Gleitschalungsfertiger 1 weist einen Maschinenrahmen 2 auf, der von einem Fahrwerk 3 getragen wird. Das Fahrwerk 3 weist zwei vordere und zwei hintere, lenkbare Laufwerke 4A, 4B auf, die an vorderen und hinteren Hubsäulen 5A, 5B befestigt sind. Die Arbeitsrichtung (Fahrtrichtung) des Gleitschalungsfertigers ist mit einem Pfeil A gekennzeichnet.

Die Laufwerke 4A, 4B und die Hubsäulen 5A, 5B sind Teil einer Antriebseinrichtung des Gleitschalungsfertigers zum Ausführen von translatorischen und/oder rotatorischen Bewegungen im Gelände. Zu der Antriebseinrichtung gehören auch nicht dargestellte vorzugsweise hydraulischen Antriebe für die Laufwerke 4A, 4B sowie ein nicht dargestellter Verbrennungsmotor. Mit den Laufwerken 4A, 4B kann die Baumaschine vor- und zurückbewegt werden. Durch Anheben und Absenken der Hubsäulen 5A, 5B kann der Maschinenrahmen 2 gegenüber dem Boden in der Höhe und Neigung bewegt werden.

Der Gleitschalungsfertiger verfügt über eine Gleitschalung 6 zum Formen von Beton, die zusammen mit dem Maschinenrahmen 2 angehoben oder abgesenkt werden kann. Zur Verdichtung des Betons sind in der Gleitschalung mehrere Betonverdichtungseinrichtungen vorgesehen, die während des Betriebs des Gleitschalungsfertiger in den Beton eintauchen. In Fig. 1 ist eine der Betonverdichtungsvorrichtungen 7 in gestrichelten Linien dargestellt. Die Betonverdichtungseinrichtungen sind konventionelle Innenrüttler, die in einer Reihe angeordnet sind. Die Innenrüttler weisen ein flaschen- oder stabförmiges Gehäuse auf, in dem ein Asynchronmotor angeordnet ist, an dessen Motorwelle eine Unwucht befestigt ist. Wenn sich die Motorwelle dreht, werden durch die Unwucht Vibrationen erzeugt, die sich auf den Beton übertragen, so dass der Beton verdichtet wird. Der Asynchronmotor wird bei dem vorliegenden Ausführungsbeispiel mit einer Wechselspannung von 110V und einer Netzfrequenz von 200 Hz (Bordnetz) betrieben.

Darüber hinaus verfügt der Gleitschalungsfertiger über eine in Fig. 1 nur schematisch dargestellte Überwachungsvorrichtung 8 zur Überwachung der Verdichtung des Betons. Die Überwachungsvorrichtung 8 weist eine Signaleinheit 8A auf, die an einem Bedienpult 9 vorgesehen ist, welches sich am Fahrerstand 10 im Sichtfeld des Bedienpersonals befindet.

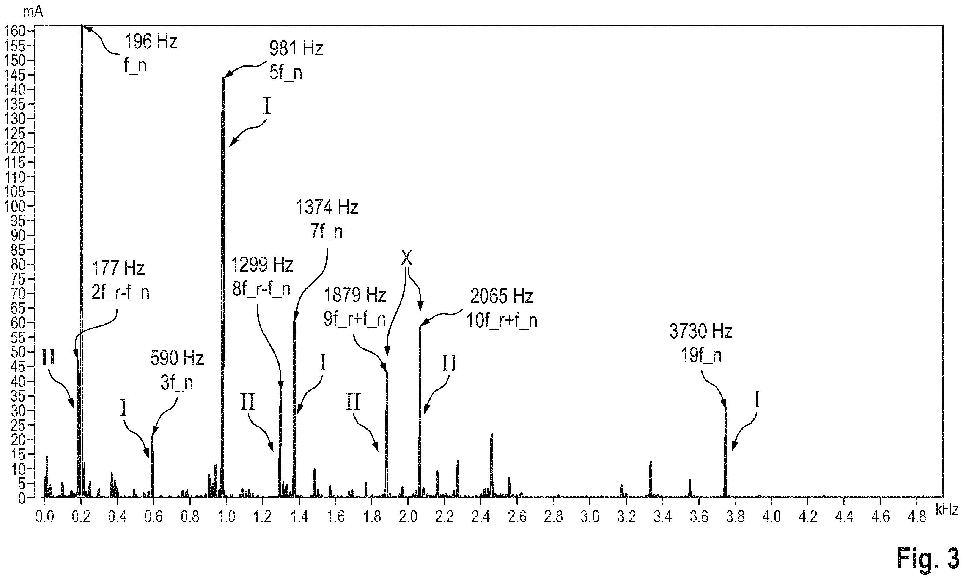

Nachfolgend wird der Aufbau und die Funktionsweise der Überwachungsvorrichtung unter Bezugnahme auf die Figuren 2 und 3 im Einzelnen beschrieben. Die Überwachungsvorrichtung weist zur Messung des Statorstroms $I_{Stator}$ einen Stromwandler 11 auf, der in den bestehenden Stromkreis des Asynchronmotors einer Betonverdichtungseinrichtung 7 des Gleitschalungsfertigers 1 integriert ist bzw. einfach integriert werden kann und eine potentialfreie Messung des Stroms erlaubt. Daher lassen sich die bekannten Gleitschalungsfertiger leicht mit der Überwachungsvorrichtung nachrüsten. Der Stromwandler transformiert den Statorstroms $I_{Stator}$ (Primärstrom) in einen Sekundärstrom $I_{sek}$. Das Messignal wird über einen Widerstand R als Spannung U abgegriffen.

Die Überwachungsvorrichtung 8 weist weiterhin einen Analog/Digital-Wandler (engl. ADC (Analog-to-Digital Converter)) 12 auf, der das analoge Messignal empfängt. Der Analog/Digital-Wandler 12 wandelt das analoge Messsignal in ein digitales Signal um.

Darüber hinaus weist die Überwachungsvorrichtung 8 eine Einrichtung 13 zur Überwachung des Statorstroms auf, die das digitale Messignal empfängt. Die Einrichtung 13 zur Überwachung des Statorstroms ist derart konfiguriert, dass die nachfolgend beschriebenen Verfahrensschritte ausgeführt werden. Sie kann beispielsweise über einen Microcontroller verfügen, der eine CPU und einen Arbeitsspeicher aufweist. Auf der Überwachungsvorrichtung kann ein Datenverarbeitungsprogramm (Software) laufen, mit dem die erforderlichen Rechenoperationen ausgeführt werden.

Das digitale Messignal wird zunächst von dem Zeitbereich in den Frequenzbereich transformiert, um das Frequenzspektrum analysieren zu können. Für die Überwachung des Statorstroms $I_{Stator}$ ist das Amplitudenspektrum von besonderem Interesse.

Die Transformation von dem Zeitbereich in den Frequenzbereich erfolgt mittels einer zeitdiskreten, schnellen Fouriertransformation (FFT/DFT). Die hierzu erforderlichen Algorithmen sind dem Fachmann bekannt. Hierzu kann eine entsprechende Software implementiert werden.

Die Rotorfrequenz (Drehzahl) $f_r$ des Asynchronmotors ergibt sich aus den folgenden Gleichungen:

$$f_H = f_n \cdot \left[ (R \pm n_d) \frac{1-s}{p} \pm v \right] \qquad \text{Gleichung (1)}$$

| | |
|---|---|
| $f_n$ | Netzfrequenz |
| $f_H$ | Frequenz einer auf die Unwucht (Exentrizität) zurückzuführenden Harmonischen |
| $R$ | Anzahl der Rotorstäbe des Asynchronmotors |
| $s$ | relativer Schlupf |
| $p$ | Poolpaarzahl |
| $n_d$ | Ordnung der Exentrizität |
| $v$ | Ordnung der Oberwellen des Netzstroms |

Da die Anzahl der Rotorstäbe $R$ des Asynchronmotors und die Poolpaarzahl $p$ bekannt ist, kann Gleichung (1) vereinfacht werden. Es sei angenommen, dass $R=9$ und $p=1$ ist. Dann ergibt sich die folgende Gleichung:

$$f_{H1} = f_n \cdot \left[ (9 \pm n_d) \frac{1-s}{p} \pm v \right] \qquad \text{Gleichung (2)}$$

Da die Ordnung der Exentrität $n_d$ unbekannt ist, wird für verschiedene, ganzzahlige Werte von $n_d$ das Amplitudenspektrum des Statorstroms analysiert. Aus diesem Grund wird $(9 +/n_d)$ zu $m$ zusammengefasst.

$$f_{H1} = f_n \cdot \left[ m \cdot (1-s) \pm v \right] = m f_r \pm v f_n \qquad m \in Z \qquad \text{Gleichung (3)}$$

$f_r$ Rotorfrequenz (Drehzahl) des Asynchronmotors

Fig. 3 zeigt ein Amplitudenspektrum des Statorstroms $I_{Stator}$, das mit dem Einrichtung 13 zur Überwachung des Statorstroms im stationären Betrieb eines Innenrüttlers ermittelt wurde. Der Innenrüttler wurde von einem Frequenzumformer anstelle eines Frequenzumrichters gespeist, um ein möglichst realistisches Spektrum zu erhalten. Die Netzfrequenz beträgt 196 Hz und ist mit f_n bezeichnet und die Rotorfrequenz wird als f_r bezeichnet. Die Rotorfrequenz $f_r$ beträgt bei dem vorliegenden Ausführungsbeispiel 186, 9 Hz. Nachfolgend wird beschrieben, wie die Rotorfrequenz $f_r$ aus dem Amplitudenspektrum ermittelt wird.

In Fig. 3 sind die auftretenden Netzharmonischen mit I und die Harmonischen, die nach Gleichung (3) berechnet werden können, mit II bezeichnet. Es sind nur Harmonische gekennzeichnet, die deutlich über dem Rauschen liegen. In dem Amplitudenspektrum können Harmonische mit folgenden Ordnungen eindeutig identifiziert werden:

$v = 1$, $m = 9$
$v = 1$, $m = 10$
$v = -1$, $m = 2$
$v = -1$, $m = 8$

Diese Werte konnten auch bei anderen Belastungen beobachtet werden. Es hat sich gezeigt, dass die Amplitude der Harmonischen ansteigt, wenn der Betonrüttler nicht mit einem Generator gespeist, sondern mit einem Frequenzumrichter betrieben wird. Dadurch lassen sich in dem Rauschen noch weitere Harmonische identifizieren. Darüber hinaus haben Messungen gezeigt, dass sich die Statorströme beim gleichzeitigen Betrieb von mehreren Betonrüttlern nicht gegenseitig beeinflussen, so dass die Drehzahl jedes Rüttlers durch eine Analyse des Statorstroms individuell bestimmt werden kann. Es hat sich auch gezeigt, dass der Unterschied zwischen Harmonischen, die aufgrund einer Unwucht (Luftspaltexzentrizität) entstehen, und Oberwellen des Netzes gut zu erkennen sind. Oberwellen des Netzes liegen bei jedem Betonrüttler bei der gleichen Frequenz. Die Harmonischen, die durch eine Luftspaltexzentrizität entstehen, liegen bei Rüttlern mit unterschiedlicher Drehzahl auch an unterschiedlichen Stellen. Dabei entstehen durch die hohen Ordnungen von $m$ auch bei kleinen Drehzahlunterschieden schon große Frequenzunterschiede im Amplitudenspektrum.

Die minimale Abtastfrequenz ist durch das Nyqist-Shannon-Abtasttheorem ($f_{abtast} > 2 f_{max}$ (Gleichung 4)) be-

stimmt.

Bei dem vorliegenden Ausführungsbeispiel ist die Abtastfrequenz 5 kHz. Da das Messsignal mit dem Analog-Digital-Wandler 12 abgetastet wird, können durch Nichteinhalten des Nyqist-Shannon-Abtasttheorems Aliasing-Effekte entstehen, die mittels Filter unterbunden werden können. Zur Verringerung der Aliasing-Effekte kann ein Antialiasing-Filter verwendet, dessen Filtercharakteristik an die auftretenden Störungen und das Nutzsignal anzupassen ist.

Durch die Umwandlung des analogen Signals in ein digitales Signal mittels des Analog-Digital-Wandlers 12 entsteht ein Quantisierungsfehler, da nur diskrete Werte gespeichert werden können. Dadurch entsteht im Frequenzbereich ein Quantisierungsrauschen, das dem Amplitudenspektrum überlagert ist. Durch Verringerung der Auflösung steigt der Rauschpegel, so dass die Harmonischen möglichweise nicht mehr eindeutig identifiziert werden können. Daher wird das aufgenommene Messsignal bei dem vorliegenden Ausführungsbeispiel nachträgliche quantisiert. In der Praxis hat sich eine Auflösung von 7 Bit als noch ausreichend erwiesen, um die Harmonischen eindeutig vom Rauschen zu unterscheiden. Mit steigender Auflösung sinkt der Rauschpegel und die Harmonischen lassen sich besser identifizieren.

Bei der zeitdiskreten, schnellen Fouriertransformation (FFT/DFT) wird eine endliche Anzahl an Messwerten benötigt. Da das Messsignal dauerhaft erfasst wird, wird aus dem Messsignal ein Zeitfenster herausgeschnitten. Ist die Fensterbreite kein Vielfaches von der Periodendauer des Signals, entsteht zwischen dem ersten und dem letzten Abtastwert eine Sprungstelle, da sich das Signal periodisch fortsetzt. Durch den Sprung entstehen im Frequenzspektrum weitere Frequenzen, die im Signal nicht vorhanden sind. Dieser Effekt wird als Leakage-Effekt bezeichnet (Meyer, Martin: Analoge und digitale Signale, Systeme und Filter, 8. Aufl., Wiesbaden: Springer Vieweg 20179). Um diesen Effekt zu vermeiden, wird das Signal bei dem vorliegenden Ausführungsbeispiel mit einer Fensterfunktion gewichtet. Durch den Leakage-Effekt sind die im Signal vorkommenden Frequenzen keine scharfen Stromspitzen im Amplitudenspektrum, sondern es entsteht bei der Frequenz eine Hauptkeule, die von mehreren Nebenkeulen umgeben ist. Bei einer Schwingung mit einer hohen Amplitude kann die Nebenkeulenantwort höher als die der Hauptkeule einer benachbarten Schwingung sein und so diese im Rauschen verschwinden lassen. Durch Variation der Fensterfunktion kann die Form der Hauptkeule und die der Nebenkeulen verändert werden, so dass eine möglichst große Anzahl von relevanten Frequenzen sicher detektiert werden können.

Bei der Analyse des Statorstroms $I_{Stator}$ können verschiedene Fensterfunktionen, die das Frequenzspektrum unterschiedlich beeinflussen, verwendet werden. Aus diesem Grund sollte eine Fensterfunktion ausgewählt werden, deren Eigenschaften an das gewünschte Spektrum angepasst ist. Das Hanning-Fenster hat gegenüber dem Rechteckfenster eine breitere Hauptkeule, die Nebenkeulen werden aber wesentlich stärker gedämpft. Da die Amplitude der Nebenkeulen von der Amplitude der Hauptkeule abhängig ist, sind bei der Statorstromanalyse vor allem jene um die Netzfrequenz interessant. Es hat sich gezeigt, dass beim Hanning-Fenster der Abstand zwischen den markierten Harmonischen und dem Rauschen am größten ist. Daher wird bei dem vorliegenden Ausführungsbeispiel das Hanning-Fenster verwendet. Es können aber auch andere Fensterfunktionen verwendet werden.

Bei einer ersten Ausführungsform der Erfindung ist die Einrichtung 13 zur Überwachung des Statorstroms des Asynchronmotors derart konfiguriert, dass die Rotorfrequenz $f_r$ (Drehzahl) aus dem mittels der schnellen Fouriertransformation aus dem Messignal ermittelten Amplitudenspektrum ermittelt wird. Die automatische Ermittlung der Rotorfrequenz $f_r$ aus dem Amplitudenspektrum erfolgt mittels eines in die Einrichtung zur Überwachung des Statorstroms implementierten Algorithmus auf der Grundlage der Verteilung von einzelnen Harmonischen über der Frequenz der spektralen Anteile im Amplitudenspektrum (Fig. 3), welche auf die Unwucht zurückzuführen sind, und der Netzfrequenz $f_n$ des Statorstroms $I_{Stator}$.

Die Werte des Amplitudenspektrums können in einem Array vorliegen. Da das Amplitudenspektrum bei einem rein reellen Signal im Zeitbereich, wie das hier verwendete Stromsignal, für positive und negative Frequenzen gleich ist, wird nur eine Hälfte des Spektrums ausgewertet. Da nicht alle lokalen Maxima im Amplitudenspektrum Harmonische sind, sondern die meisten durch Rauschen entstehen, werden nur Werte untersucht, die einen vorgegebenen Schwellwert überschreiten. Ist der Schwellwert zu hoch, werden die Harmonischen, die Informationen zu der Rotorfrequenz $f_r$ enthalten, nicht untersucht. Ist der Schwellwert zu niedrig, wird Rauschen als Harmonische interpretiert. Da bei unterschiedlicher Belastung und Drehzahl die Amplitude der Harmonischen variiert, wird nicht ein absoluter Wert als Schwellwert angegeben, sondern der Schwellwert wird relativ bestimmt, indem die Anzahl der höchsten Werte angegeben wird. Um die höchsten Amplituden zu ermitteln, wird mittels eines geeigneten Algorithmus, beispielsweise eines Bubblesort-Algorithmus, das Amplitudenspektrum absteigend sortiert. Da nicht alle Werte sortiert werden müssen, wird der Bubblesort-Algorithmus nach Erreichen einer vorgegebenen Anzahl abgebrochen. Die Frequenz mit der höchsten Amplitude wird als die Netzfrequenz $fn$ angenommen. Die kleinste Amplitude der sortierten Werte wird als Schwellwert definiert. Anschließend werden die Werte oberhalb des Schwellwertes wieder nach ihrer Frequenz aufsteigend sortiert.

Da die höchste beobachtete Frequenz einer Harmonischen bei einer Ordnung von $v = 1$ und $m = 10$ vorkommt, werden alle Amplituden oberhalb der Frequenz

$$f_{ignore} \geq f_n \cdot [1 + 10 \cdot (1 - s_{min})] \qquad \text{(Gleichung 5)}$$

ignoriert. Dabei ist $s_{min}$ der minimale Schlupf, der bei den Betonverdichtungseinrichtungen auftritt. Dadurch kann verhindert werden, dass Netzharmonische als passende Harmonische interpretiert werden, da bei einem Schlupf von null Netzharmonische und Harmonische, die aufgrund der Exzentrizität entstehen, bei derselben Frequenz liegen.

Anschließend wird mit der größten Frequenz beginnend untersucht, ob die aktuelle Amplitude eine passende Harmonische ist. Dies ist dann der Fall, wenn bei der errechneten Rotorfrequenz $f_r$ die Amplitude mehrerer Harmonischen den Schwellwert überschreiten. Da nicht alle Harmonischen immer vorhanden sind, muss nur bei zwei der vier Harmonischen eine Übereinstimmung bestehen. Eine nachträgliche Änderung der Anzahl der Übereinstimmungen ist jedoch jederzeit möglich.

Bei dem vorliegenden Ausführungsbeispiel werden die in Fig. 3 mit X gekennzeichneten Harmonischen bei $v$ = 1, $m$ = 9 und $v$ = 1, $m$ = 10 untersucht. Dazu wird die aktuell untersuchte Frequenz als $f_{m=10}$ definiert und anschließend wird $f_{m=9}$ nach der folgenden Gleichung berechnet:

$$f_{m=9} = f_r \cdot 9 + f_{nt} = \frac{9 \cdot f_{m=10} + f_{n\_est}}{10} \qquad \text{Gleichung (6)}$$

Daraufhin wird die Rotorfrequenz $f_{r\_est}$ nach der folgenden Gleichung berechnet:

$$f_r = \frac{(f_{m=10} - f_{n\_est})}{10} \qquad \text{(Gleichung 7)}$$

Da im Amplitudenspektrum nur diskrete Frequenzwerte vorhanden sind, kann eine lineare Interpolation verwendet werden, um die Amplitude von $f_{m=9}$ im ursprünglichen Spektrum zu erhalten. Es hat sich gezeigt, dass es schon auf der Grundlage von zwei Harmonischen im Amplitudenspektrum möglich ist, die Rotorfrequenz ausreichend sicher zu detektieren. Werden weitere Harmonische in den Algorithmus eingebunden, kann die Zuverlässigkeit der Bestimmung der Rotorfrequenz $f_r$ (Drehzahl) noch weiter erhöht werden.

Die Einrichtung zur Überwachung des Statorstroms $I_{Stator}$ bestimmt die Rotorfrequenz $f_r$ (Drehzahl) des Asynchronmotors für jede Betonverdichtungsvorrichtung der Mehrzahl von Betonverdichtungsvorrichtung, die bei dem Gleitschalungsfertiger verwendet werden. Die Bestimmung der Drehzahl der Asynchronmotoren sämtlicher Betonverdichtungsvorrichtungen kann gleichzeitig oder nacheinander erfolgen. Für die gleichzeitige Bestimmung der Drehzahl werden sämtliche Messsignale auf Grundlage der oben beschriebenen Verfahrensschritten gleichzeitig analysiert, was eine höhere Rechenleistung erfordert.

Nach der Bestimmung der Rotorfrequenzen (Drehzahl) der Asynchronmotoren der einzelnen Betonverdichtungsvorrichtungen, wird die Drehzahl jedes Asynchronmotors mit einem für den Motor vorgegebenen Grenzwert verglichen. Da im Allgemeinen die gleichen Betonrüttler verwendet werden, ist die Vorgabe eines einzigen Grenzwertes ausreichend.

Die Einrichtung 13 zur Überwachung des Statorstroms $I_{Stator}$ ist derart konfiguriert, dass für jede Betonverdichtungsvorrichtung ein Steuersignal erzeugt wird, wenn die Rotorfrequenz (Drehzahl) von deren Asynchronmotor den Grenzwert unterschreitet. Ein Steuersignal kann aber auch erzeugt werden, wenn der Grenzwert überschritten wird.

Die Überwachungsvorrichtung 8 weist weiterhin eine die Steuersignale der Einrichtung 13 zur Überwachung des Statorstroms empfangende Signaleinheit 8A aufweist, die derart ausgebildet ist, dass mit einem akustischen und/oder optischen und/oder einem taktilen Signal eine nicht ordnungsgemäße Verdichtung des Betons beim Betrieb des Gleitschalungsfertigers angezeigt wird, wenn die Signaleinheit das jeweilige Steuersignal empfängt oder dass mit einem akustischen und/oder optischen und/oder einem taktilen Signal eine ordnungsgemäße Verdichtung des Betons beim Betrieb des Gleitschalungsfertigers angezeigt wird, wenn die Signaleinheit das Steuersignal nicht empfängt.

Die Signaleinheit 8A kann am Bedienpult 9 des Gleitschalungsfertigers 1 vorgesehen sein (Fig. 1). Sie kann mehrere Signallampen 14 aufweisen, wobei jeder Betonverdichtungsvorrichtung eine Signallampe zugeordnet sein kann, die eine nicht ordnungsgemäße Verdichtung des Betons, beispielsweise eine rote Signallampe, und/oder eine Signallampe zugeordnet sein kann, die eine ordnungsgemäße Verdichtung des Betons, beispielsweise eine grüne Signallampe, signalisiert. Die Anzeige der Betriebszustände kann aber auch mit graphischen Symbolen, beispielsweise auf einem Display erfolgen. Für sämtliche Betonverdichtungseinrichtungen können auch nur eine Signallampe oder ein graphisches Symbol zur Signalisierung eines nicht ordnungsgemäßen bzw. ordnungsgemäßen Betriebs vorgesehen sein, wobei die Rotorfrequenzen bzw. das Über- oder Unterschreiten des Grenzwertes statistisch ausgewertet werden. Beispielsweise kann auf eine nicht ordnungsgemäße Verdichtung des Betons erst dann geschlossen werden, wenn für eine bestimmte Anzahl von Betonverdichtungsvorrichten und/oder für einen bestimmten Zeitraum der vorgegebene Grenzwert unterschritten wird.

Die Überwachungsvorrichtung 8 kann auch eine Anzeigeeinheit zur Anzeige der ermittelten Drehzahl der Asynchronmotoren der Betonverdichtungsvorrichtungen aufweisen.

Nachfolgend wird eine alternative Ausführungsform der Überwachungsvorrichtung 8 beschrieben, die sich von der ersten Ausführungsform dadurch unterscheidet, dass für den Schluss auf eine ordnungsgemäße oder nicht ordnungsgemäße Verdichtung des Betons nicht die Rotorfrequenz $f_r$ (Drehzahl) des Asynchronmotors bestimmt wird, sondern die Verteilung von einzelnen Harmonischen X über der Frequenz der spektralen Anteile, welche auf die Unwucht zurückzuführen sind, fortlaufend ermittelt wird und mit einer für eine vorgegebene Drehzahl des Asynchronmotors charakteristischen Verteilung von einzelnen Harmonischen über der Frequenz der spektralen Anteile verglichen wird. Bei dieser Ausführungsform sind in einem Speicher 13A der Einrichtung 13 zur Überwachung des Statorstroms $I_{Stator}$ für die einzelnen Betonverdichtungseinrichtungen charakteristische Muster einer spektralen Verteilung gespeichert, die empirisch ermittelt werden können. Da in der Praxis die gleichen Betonrüttler verwendet werden, ist nur ein charakteristisches Muster erforderlich. Es ist aber auch möglich, in dem Speicher 13A charakteristische Muster für unterschiedliche Typen von Betonrüttlern zu speichern, wobei das jeweilige Muster dann für den verwendeten Typ vom Bedienpersonal ausgewählt wird.

Die Einrichtung 13 zur Überwachung des Statorstroms ist derart konfiguriert, dass ein Steuersignal erzeugt wird, das eine Veränderung der Verdichtung des in die Gleitschalung des Gleitschalungsfertigers eingebrachten Betons signalisiert, wenn die Verteilung von einzelnen Harmonischen X über der Frequenz der spektralen Anteile, welche auf die Unwucht zurückzuführen sind, von einer für eine vorgegebene Drehzahl des Asynchronmotors charakteristischen Verteilung von einzelnen Harmonischen unter Berücksichtigung bestimmter Kriterien abweicht. Die Abweichung kann mit geeigneten Algorithmen festgestellt werden, die dem Fachmann bekannt sind. Beispielsweise können mit den oben beschriebenen Rechenoperationen die Frequenzen von beispielsweise zwei auf die Unwucht zurückzuführende Harmonischen X ermittelt und mit für eine vorgegebene Drehzahl des Asynchronmotors charakteristischen Frequenzen in einem empirisch ermittelten Muster verglichen werden. Wenn die Frequenzen der Harmonischen nicht innerhalb vorgegebener Frequenzbereiche liegen, wird auf eine nicht ordnungsgemäße Verdichtung des Betons geschlossen und das Steuersignal erzeugt. Die Zuverlässigkeit kann wieder dadurch erhöht werden, dass mehr als zwei Harmonische in dem Amplitudenspektrum identifiziert und analysiert werden. Der Vergleich der Muster kann mit den bekannten Algorithmen erfolgen.

## Patentansprüche

1. Gleitschalungsfertiger mit einer Überwachungsvorrichtung zur Überwachung der Verdichtung von in eine Gleitschalung des Gleitschalungsfertigers eingebrachten Betons mit mindestens einer Betonverdichtungsvorrichtung, die einen Asynchronmotor zum Antrieb einer Vibrationen erzeugenden Unwucht aufweist,
**dadurch gekennzeichnet, dass**

   die Überwachungsvorrichtung (8) eine Einrichtung (13) zur Überwachung des Statorstroms ($I_{Stator}$) des Asynchronmotors der mindestens einen Betonverdichtungsvorrichtung aufweist, die derart konfiguriert ist, dass auf der Grundlage einer Analyse des Statorstroms ($I_{Stator}$) des Asynchronmotors auf eine Veränderung der Verdichtung des in die Gleitschalung des Gleitschalungsfertigers eingebrachten Betons geschlossen wird, wobei die Einrichtung (13) zur Überwachung des Statorstroms ($I_{Stator}$) des Asynchronmotors derart konfiguriert ist, dass zur Analyse des Statorstroms das Amplitudenspektrum des Statorstroms ermittelt wird
   der Statorstrom abgetastet wird, wobei das Amplitudenspektrum des Statorstroms durch eine zeitdiskrete Fouriertransformation (DFT), insbesondere eine zeitdiskrete schnelle Fouriertransformation (FFT), des Statorstroms ermittelt wird, und
   die Verteilung von einzelnen Harmonischen (X) über der Frequenz der spektralen Anteile, welche auf die Unwucht zurückzuführen sind, fortlaufend ermittelt wird und mit einer für eine vorgegebene Drehzahl des Asynchronmotors charakteristischen Verteilung von einzelnen Harmonischen über der Frequenz der spektralen Anteile verglichen wird, wobei bei einer Abweichung der Verteilung von den einzelnen Harmonischen ein Steuersignal erzeugt wird, das eine Veränderung der Verdichtung des in die Gleitschalung des Gleitschalungsfertigers eingebrachten Betons signalisiert.

2. Gleitschalungsfertiger nach Anspruch 1, **dadurch gekennzeichnet, dass** die Einrichtung (13) zur Überwachung des Statorstroms des Asynchronmotors derart konfiguriert ist, dass zur Analyse des Statorstroms ($I_{Stator}$) des Asynchronmotors ein Schwellwert für die Amplituden der Harmonischen vorgegeben wird, wobei die Verteilung von einzelnen Harmonischen (X) über der Frequenz der spektralen Anteile, die über dem Schwellwert liegen, ermittelt wird.

3. Gleitschalungsfertiger nach Anspruch 1 oder 2, **dadurch gekennzeichnet, dass** die Überwachungsvorrichtung(8) eine das Steuersignal empfangende Signaleinheit (8A) aufweist, die derart ausgebildet ist, dass mit einem akustischen und/oder optischen und/oder einem taktilen Signal eine nicht ordnungsgemäße Verdichtung des Betons beim Betrieb des Gleitschalungsfertigers angezeigt wird, wenn die Signaleinheit das Steuersignal empfängt, oder dass mit einem akustischen und/oder optischen und/oder einem taktilen Signal eine ordnungsgemäße Verdichtung des Betons beim Betrieb des Gleitschalungsfertigers angezeigt wird, wenn die Signaleinheit das Steuersignal nicht empfängt.

4. Verfahren zur Überwachung der Verdichtung von in eine Gleitschalung eines Gleitschalungsfertigers eingebrachten Betons mit mindestens einer Betonverdichtungsvorrichtung, die einen Asynchronmotor zum Antrieb einer Vibrationen erzeugenden Unwucht aufweist, während des Betriebs des Gleitschlaungsfertigers, **dadurch gekennzeichnet, dass** der Statorstroms ($I_{Stator}$) des Asychronmotors der mindestens einen Betonverdichtungsvorrichtung überwacht wird, wobei auf der Grundlage einer Analyse des Statorstroms ($I_{Stator}$) auf eine Veränderung der Verdichtung des in die Gleitschalung des Gleitschalungsfertigers eingebrachten Betons geschlossen wird, wobei

zur Analyse des Statorstroms ($I_{Stator}$) das Amplitudenspektrum des Statorstroms ermittelt wird,
das Amplitudenspektrum des Statorstroms ($I_{Stator}$) durch eine zeitdiskrete Fouriertransformation (DFT), insbesondere eine zeitdiskrete schnelle Fouriertransformation (FFT), des Statorstroms ermittelt wird und
die Verteilung von einzelnen Harmonischen (X) über der Frequenz der spektralen Anteile, welche auf die Unwucht zurückzuführen sind, fortlaufend ermittelt wird und mit einer für eine vorgegebene Drehzahl des Asynchronmotors charakteristischen Verteilung von einzelnen Harmonischen über der Frequenz der spektralen Anteile verglichen wird, wobei bei einer Abweichung der Verteilung von den einzelnen Harmonischen ein Steuersignal erzeugt wird, das eine Veränderung der Verdichtung des in die Gleitschalung des Gleitschalungsfertigers eingebrachten Betons signalisiert.

5. Verfahren nach Anspruch 4, **dadurch gekennzeichnet, dass** zur Analyse des Statorstroms ($I_{Stator}$) des Asynchronmotors ein Schwellwert für die Amplituden der Harmonischen vorgegeben wird, wobei die Verteilung von einzelnen Harmonischen (X) über der Frequenz der spektralen Anteile, die über dem Schwellwert liegen, ermittelt wird.

6. Verfahren nach Anspruch 4 oder 5, **dadurch gekennzeichnet, dass** mit einem akustischen und/oder optischen und/oder einem taktilen Signal eine nicht ordnungsgemäßer Verdichtung des Betons beim Betrieb des Gleitschalungsfertigers angezeigt wird, wenn das Steuersignal erzeugt wird, oder dass mit einem akustischen und/oder optischen und/oder einem taktilen Signal eine ordnungsgemäße Verdichtung des Betons beim Betrieb des Gleitschalungsfertigers angezeigt wird, wenn das Steuersignal nicht erzeugt wird.

**Claims**

1. Slipform paver comprising a monitoring device for monitoring the compaction of concrete introduced into a slipform of the slipform paver by means of at least one concrete compacting device which has an asynchronous motor for driving an unbalanced mass which generates vibrations,
   **characterised in that**

   the monitoring device (8) comprises an apparatus (13) for monitoring the stator current ($I_{Stator}$) of the asynchronous motor of the at least one concrete compacting device, said monitoring apparatus being configured such that a change in the compaction of the concrete introduced into the slipform of the slipform paver is determined based on an analysis of the stator current ($I_{sta-tor}$) of the asynchronous motor,
   the apparatus (13) for monitoring the stator current ($I_{Stator}$) of the asynchronous motor being configured such that the amplitude spectrum of the stator current is determined in order to analyse the stator current,
   the stator current is sampled, the amplitude spectrum of the stator current being determined by a discrete-time Fourier transform (DFT), in particular a discrete-time fast Fourier transform (FFT), of the stator current, and
   the distribution of individual harmonics (X), which are attributable to the unbalanced mass, over the frequency of the spectral components is continuously determined and is compared with a distribution of individual harmonics over the frequency of the spectral components, which distribution is characteristic of a predefined speed of the asynchronous motor, a control signal being generated when a deviation occurs in the distribution of the individual harmonics, which control signal signals a change in the compaction of the concrete introduced into the slipform of the slipform paver.

**2.** Slipform paver according to claim 1, **characterised in that** the apparatus (13) for monitoring the stator current of the asynchronous motor is configured such that a threshold value for the amplitudes of the harmonics is predefined for the analysis of the stator current ($I_{Stator}$) of the asynchronous motor, the distribution of individual harmonics (X) over the frequency of the spectral components that are above the threshold value being determined.

**3.** Slipform paver according to claim 1 or 2, **characterised in that** the monitoring device (8) has a signal unit (8A) that receives the control signal and is designed such that improper compaction of the concrete during operation of the slipform paver is indicated by means of an acoustic and/or optical and/or tactile signal when the signal unit receives the control signal, or that proper compaction of the concrete during operation of the slipform paver is indicated by an acoustic and/or optical and/or a tactile signal when the signal unit does not receive the control signal.

**4.** Method for monitoring, during operation of the slipform paver, the compaction of concrete introduced into a slipform of a slipform paver by means of at least one concrete compacting device which has an asynchronous motor for driving an unbalanced mass which generates vibrations, **characterised in that** the stator current ($I_{Stator}$) of the asynchronous motor of the at least one concrete compacting device is monitored, a change in the compaction of the concrete introduced into the slipform of the slipform paver being determined based on an analysis of the stator current ($I_{stator}$),

the amplitude spectrum of the stator current being determined in order to analyse the stator current ($I_{stator}$), amplitude spectrum of the stator current ($I_{Stator}$) being determined by a discrete-time Fourier transformation (DFT), in particular a discrete-time fast Fourier transformation (FFT), of the stator current, and the distribution of individual harmonics (X), which are attributable to the unbalanced mass, over the frequency of the spectral components being continuously determined and being compared with a distribution of individual harmonics over the frequency of the spectral components, which distribution is characteristic of a predefined speed of the asynchronous motor, a control signal being generated when a deviation occurs in the distribution of the individual harmonics, which control signal signals a change in the compaction of the concrete introduced into the slipform of the slipform paver.

**5.** Method according to claim 4, **characterised in that** a threshold value for the amplitudes of the harmonics is predefined for the analysis of the stator current ($I_{Stator}$) of the asynchronous motor, the distribution of individual harmonics (X) over the frequency of the spectral components that are above the threshold value being determined.

**6.** Method according to claim 4 or 5, **characterised in that** improper compaction of the concrete during operation of the slipform paver is indicated by means of an acoustic and/or optical and/or tactile signal when the control signal is generated, or **in that** proper compaction of the concrete during operation of the slipform paver is indicated by means of an acoustic and/or optical and/or a tactile signal when the control signal is not generated.

**Revendications**

**1.** Machine à coffrage glissant avec un dispositif de surveillance pour la surveillance du compactage d'un béton introduit dans un coffrage glissant de la machine à coffrage glissant, avec au moins un dispositif de compactage de béton, qui comprend un moteur asynchrone pour l'entraînement d'un balourd générant des vibrations,
**Caractérisée en ce que**

Le dispositif de surveillance (8) comprend un dispositif (13) pour la surveillance du courant de stator ($I_{Stator}$) du moteur asynchrone de l'au moins un dispositif de compactage de béton, qui est conçu de sorte que, sur la base d'une analyse du courant de stator ($I_{Stator}$) du moteur asynchrone, on en déduit une variation du compactage du béton introduit dans le coffrage glissant de la machine à coffrage glissant, dans laquelle
Le dispositif (13) pour la surveillance du courant de stator ($I_{Stator}$) du moteur asynchrone est conçu de sorte que, pour l'analyse du courant de stator, le spectre d'amplitude du courant de stator est déterminé
Le courant de stator est échantillonné, dans laquelle le spectre d'amplitude du courant de stator est déterminé à l'aide d'une transformation de Fourier discrète dans le temps (DFT), plus particulièrement une transformation de Fourier rapide discrète dans le temps (FFT), du courant de stator et
la distribution d'harmoniques individuelles (X) sur la fréquence des parties du spectre qui sont dues au balourd est déterminée de manière continue et est comparée avec une distribution, caractéristique d'une vitesse de rotation prédéterminée du moteur asynchrone, d'harmoniques individuelles sur la fréquence des parties du spectre, dans laquelle, en cas d'écart de la distribution par rapport aux harmoniques individuelles, un signal de commande est généré, qui signale une variation du compactage du béton introduit dans le coffrage glissant de la machine à coffrage glissant.

**2.** Machine à coffrage glissant selon la revendication 1, **caractérisé en ce que** le dispositif (13) pour la surveillance du courant de stator du moteur asynchrone est conçu de sorte que, pour l'analyse du courant de stator ($I_{Stator}$) du moteur asynchrone, une valeur seuil est prédéterminée pour les amplitudes des harmoniques, dans laquelle la distribution d'harmoniques individuelles (X) sur la fréquence des parties du spectre qui se trouvent au-dessus de la valeur seuil, est déterminée.

**3.** Machine à coffrage glissant selon la revendication 1 ou 2, **caractérisé en ce que** le dispositif de surveillance (8) comprend une unité de signalisation (8A) recevant le signal de commande, qui est conçue de sorte que, avec un signal acoustique et/ou optique et/ou tactile, un compactage incorrect du béton lors du fonctionnement de la machine à coffrage glissant est signalé lorsque l'unité de signalisation reçoit le signal de commande, ou de sorte que, avec un signal acoustique et/ou optique et/ou tactile, un compactage correct du béton lors du fonctionnement de la machine à coffrage glissant est signalé lorsque l'unité de signalisation ne reçoit pas le signal de commande.

**4.** Procédé de surveillance du compactage du béton introduit dans un coffrage glissant d'une machine à coffrage glissant, avec au moins un dispositif de compactage de béton qui comprend un moteur asynchrone pour l'entraînement d'un balourd générant des vibrations, pendant le fonctionnement de la machine à coffrage glissant, **caractérisé en ce que** le courant de stator ($I_{Stator}$) du moteur asynchrone de l'au moins un dispositif de compactage de béton est surveillé, dans lequel, sur la base d'une analyse du courant de stator ($I_{stator}$), on en déduit une variation du compactage du béton introduit dans le coffrage glissant de la machine à coffrage glissant, dans lequel

Pour l'analyse du courant de stator ($I_{stator}$), le spectre d'amplitude du courant de stator est déterminé,
Le spectre d'amplitude du courant de stator ($I_{stator}$) est déterminé à l'aide d'une transformation de Fourier discrète dans le temps (DFT), plus particulièrement une transformation de Fourier rapide discrète dans le temps (FFT), du courant de stator et
la distribution d'harmoniques individuelles (X) sur la fréquence des parties du spectre qui sont dues au balourd est déterminée de manière continue et est comparée avec une distribution, caractéristique d'une vitesse de rotation prédéterminée du moteur asynchrone, d'harmoniques individuelles sur la fréquence des parties du spectre, dans laquelle, en cas d'écart de la distribution par rapport aux harmoniques individuelles, un signal de commande est généré, qui signale une variation du compactage du béton introduit dans le coffrage glissant de la machine à coffrage glissant.

**5.** Procédé selon la revendication 4, **caractérisé en ce que**, pour l'analyse du courant de stator ($I_{stator}$) du moteur asynchrone, une valeur seuil est prédéterminée pour les amplitudes des harmoniques, dans lequel la distribution de harmoniques individuelles (X) sur la fréquence des parties du spectre qui se trouvent au-dessus de la valeur seuil est déterminée.

**6.** Procédé selon la revendication 4 ou 5, **caractérisé en ce que**, avec un signal acoustique et/ou optique et/ou tactile, un compactage incorrect du béton lors du fonctionnement de la machine à coffrage glissant est signalé lorsque le signal de commande est généré ou **en ce que**, avec un signal acoustique et/ou optique et/ou tactile, un compactage correct du béton lors du fonctionnement de la machine à coffrage glissant est signalé lorsque le signal de commande n'est pas généré.

**Fig. 1**

**Fig. 2**

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1103659 B1
- DE 10354002 A1
- EP 2942867 A2